# EUROPÄISCHE PATENTSCHRIFT

(11) **EP 1 093 687 B1**
(45) Veröffentlichungstag und Bekanntmachung des Hinweises auf die Patenterteilung: **13.03.2002**
(21) Anmeldenummer: 99944248.6
(22) Anmeldetag: 01.07.1999
(51) Int. Cl.: H03M 1/06

(54) **LINEARISIERTER MULTI-BIT-DIGITAL/ANALOG-WANDLER UND SEINE VERWENDUNG IN EINEM MULTI-BIT-DELTA-SIGMA-ANALOG/DIGITAL-WANDLER**
LINEARIZED MULTI-BIT DIGITAL/ANALOG CONVERTER AND THE USE THEREOF IN A MULTI-BIT DELTA-SIGMA ANALOG/DIGITAL CONVERTER
CONVERTISSEUR NUMERIQUE/ANALOGIQUE A BITS MULTIPLES LINEARISE ET SON UTILISATION DANS UN CONVERTISSEUR ANALOGIQUE NUMERIQUE DELTA SIGMA A BITS MULTIPLES

(30) Priorität: 07.07.1998 DE 19830355; 28.08.1998 DE 19839282
(43) Veröffentlichungstag der Anmeldung: 25.04.2001
(73) Patentinhaber: Infineon Technologies AG, 81669 München (DE)
(72) Erfinder: BRAUN, Christoph, D-52335 Düren (DE)
(74) Vertreter: Viering, Jentschura & Partner
(86) Internationale Anmeldenummer: DE9901979
(87) Internationale Veröffentlichungsnummer: WO0002318

(56) Entgegenhaltungen:
- EP-A- 0 704 978
- US-A- 5 404 142
- SCHREIER R ET AL: "NOISE-SHAPED MULTBIT D/A CONVERTOR EMPLOYING UNIT ELEMENTS" ELECTRONICS LETTERS,GB,IEE STEVENAGE, Bd. 31, Nr. 20, Seite 1712-1713 XP000538060 ISSN: 0013-5194 in der Anmeldung erwähnt

## Beschreibung

Delta-Sigma-AD-Wandler werden ungefähr seit Mitte der achtziger Jahre für die Digitalisierung von Audiosignalen eingesetzt. Zahlreiche Untersuchungen und viele wissenschaftliche Abhandlungen der letzten drei Jahrzehnte führten zu einem immer größeren Einsatzbereich dieser Wandler. Ein derartiger Wandler weist eine Regelschleife auf, in deren vorwärtszweig ein Schleifenfilter und ein Quanitisierer und im Rückkopplungszweig ein D/A-Wandler vorhanden sind. Mit Modulatorstrukturen höherer Ordnung und Multi-Bit-D/A-Wandler werden derartige Wandler nun auch zunehmend für den höherfrequenten Bereich oberhalb des Audiobereiches versucht.

Sigma-Delta-A/D-Wandler tasten das analoge Eingangssignal mit einer wesentlich höheren Rate ab als sogenannte Nyquist-Wandler. Die Amplitudenauflösung wird hierbei gegen eine Zeitauflösung eingetauscht. Durch ein sogenanntes Dezimierungsfilter kann wie bisher, ein Datenstrom mit hoher Auflösung und geringer Rate erzeugt werden. Durch Verwendung von Multi-Bit-D/A-Wandlern; anstelle von Ein-Bit-D/A-Wandlern, kann die Überabtastrate (Oversampling) aufgrund des geringeren Quantisierungsrauschens wesentlich verringert werden. Zudem können Schleifenfilter mit geringerer Phasenreserve und damit größerer Tiefpaßbereich -Verstärkung verwendet werden, die einen noch besseren Geräuschspannungsabstand ermöglichen. Allerdings ist hierbei die Linearität im wesentlichen nur abhängig von der Genauigkeit des D/A-Wandlers, denn die Regelschleife des Modulators unterdrückt nicht die Störungen durch den D/A-Wandler. Aufgrund der Überabtastung bei der Delta-Sigma-Modulation kann der störende Einfluß der Toleranz der Elemente im D/A-Wandler auf das Nutzsignal mittels Rauschformung (Noise-Shaping) erheblich gemindert werden. Ohne eine Rauschformung werden beim D/A-Wandler in Abhängigkeit eines Eingangssignals entsprechend viele D/A-Elemente ausgewählt und deren Ausgangssignale zu einem Ausgangssignal des D/A-Wandlers aufsummiert.

In an sich bekannter Weise können die Auswirkungen von fertigungsbedingten Unterschieden der Elemente des Digital/Analog-Wandlers durch eine entsprechende Element-Selektionsschaltung deutlich reduziert werden. Ein entsprechendes Verfahren wird beispielsweise in Electronic Letters, Vol. 31, No. 20, 28.09.1995, beschrieben. Zur Erzeugung einer Rauschformung wird hierbei als D/A-Wandler eine Schaltung aus einheitlichen Delta-Sigma-Modulatoren verwendet, die über einen gemeinsamen Vektor-Quantisierer gekoppelt sind. Der Vektor-Quantisierer sorgt dafür, daß die vom Eingangssignal vorgegebene Anzahl an Elementen von den Delta-Sigma-Modulatoren ausgewählt werden, wobei gerade die Modulatoren ausgewählt werden, die das größte Ausgangssignal aufweisen. Der Vektor-Quantisierer übernimmt hierbei auch die übliche Funktion eines Quantisierers bei der Delta-Sigma-Modulation, da die Rückkopplung über das Ausgangssignal des Vektor-Quantisierers erfolgt. Zur Stabilisierung des Gesamtsystems wird als Eingangssignal für die Delta-Sigma-Modulation die Ausgangskomponente des Vektorfilters mit dem kleinsten Wert genommen. Die beim Stand der Technik vorgestellte Architektur mit der entsprechenden Stabilisierung über das Eingangssignal bedingt einen hohen schaltungstechnischen Aufwand des Vektor-Quanitisierers und erfordert zusätzlich eine Minimumdetektion. Ferner ist die gewählte Struktur für die Delta-Sigma-Modulatoren sehr koeffizienten-fehlerempfindlich und erfordert daher, bei komplexen Filterstrukturen, Koeffizientenmultiplizierer mit großer Wortbreite.

Die der Erfindung zugrundeliegende Autgabe besteht nun darin, einen Multi-Bit-D/A-Wandler mit einer Rauschformung derart anzugeben, daß die Störungen durch den D/A-Wandler aufgrund der Bauelementetoleranzen deutlich reduziert, werden und der oben erwähnte schaltungstechnische Mehraufwand vermieden wird.

Diese Aufgabe wird erfindungsgemäß durch die Merkmale des Patentanspruchs 1 gelöst. Weitere Ansprüche betreffen vorteilhafte Ausgestaltungen der Erfindung und eine bevorzugte Verwendung.

Die Erfindung wird im folgenden anhand von in den Zeichnungen dargestellten Beispielen näher erläutert. Dabei zeigt
- Figur 1: einen Delta-Sigma-A/D-Wandler mit einer Rauschformung für einen Drei-Bit-D/A-Wandler,
- Figur 2: eine Tabelle zur Beschreibung-einer Sortierlogik von Figur 1,
- Figur 3: ein Schaltbild zur Erläuterung einer besonderen Ausgestaltung eines Schleifenfilters im Rückkoppelzweig und
- Figur 4: eine weitere Ausführungsform des Schleifenfilters im Rückkoppelzweig von Figur 1.

Die Grundidee der Erfindung besteht darin, daß M Delta-SigmaModulatoren und M DA-Elemente vorhanden sind und jeder Modulator sein zugehöriges DA-Element derart selektiert, daß das resultierende Signal eines jeweiligen Elementes für sich allein betrachtet das Eingangssignal des D/A-Wandlers nachbildet. Das analoge Ausgangssignal des D/A-Wandlers ergibt sich dann aus der Überlagerung der einzelnen Signale der M DA-Elemente. Das Eingangssignal der M-Delta-Sigma-Modulatoren entspricht dabei dem M-ten Teil des Eingangssignales des Digital/Analog-Wandlers.

Die Erfindung führt zu einer erheblichen Reduzierung des Schaltungsaufwandes, da hier insbesondere die Quantisierer. mit einer geringer Stufenzahl realisierbar sind, ohne daß dabei Instabilitäten auftreten. Durch eine Zustandsvektorrückführung oder Zustandswertbegrenzung in den Schleifenfiltern des erfindungsgemäßen Digital/Analogwandlers sind, im Gegensatz zum Stand der Technik, auch stabile Delta-Sigma-Wandler mit einer Ordnung > 2 mit einem relativ geringen Schaltungsaufwand möglich.

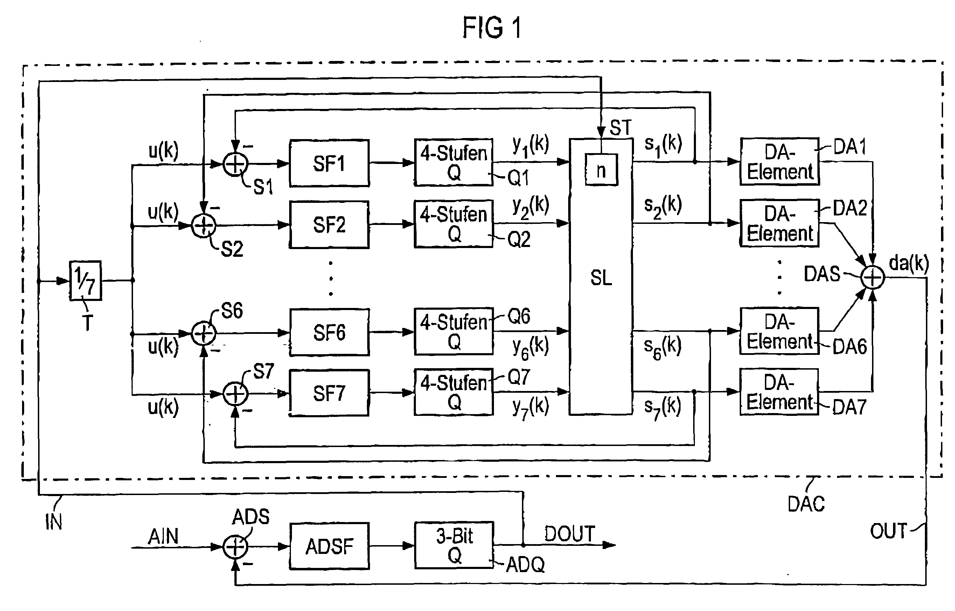

In Figur 1 ist ein Ausführungsbeispiel eines Multibit Delta-Sigma-A/D-Wandlers dargestellt, der im Vorwärtspfad der Reihe nach einen Summierer ADS, ein Schleifenfilter ADF und einen Multi-Bit-Quantisierer ADQ, mit beispielsweise drei Bit-Auflösung, sowie einen Rückkoppelpfad vom digitalen Ausgang DOUT des Delta-Sigma-A/D-Wandlers zum negativen Eingang des Summierers ADS mit einem erfindungsgemäßen Multi-Bit-Digital/Analog-Wandler DAC aufweist. Im Summierer ADS wird von analogen Amplitudenproben AIN ein analoges Ausgangssignal da (k) des Wandlers DAC subtrahiert. Das Ausgangssignal DOUT stellt das Eingangssignal IN des Digital/Analog-Wandlers DAC dar und wird in einer Teilerschaltung T durch die Anzahl M der im D/A-Wandler vorhandenen DA-Elementen geteilt. Hier sind M = 7 gleiche DA-Elemente DA1 ... DA7 vorhanden, deren ausgangsseitige Signale mit Hilfe eines Summierers DAS das analoge Ausgangssignal da (k) am Ausgang OUT des Digital/Analog-Wandlers DAC bilden. Als DA-Elemente dienen beispielsweise Widerstände, ähnlich wie bei einem Summationsverstärker in der Analogtechnik. Da die DA-Elemente, abgesehen von den Bauelementetoleranzen, alle gleich groß sind, ist nur die absolute Anzahl der ausgewählten DA-Elemente und nicht die spezielle Auswahl der DA-Elemente für das Signal da (k) von Bedeutung. Durch eine Sortierlogik SL werden aus M = 7 Ausgangssignalen y1 (k) ... y7 (k) von entsprechend vielen Multi-Bit-Quantisierern Q1 ... Q7, mit bzw. zwei Bit Auflösung, in Abhängigkeit des Eingangssignals IN, M Auswahlsignale s1 (k) ... s7 (k) für die M = 7 DA-Elemente gebildet. Aus dem Signal am Eingang IN bzw. am Eingang ST der Sortierlogik SL wird in der Sortierlogik die Anzahl n der auszuwählenden DA-Elemente ermittelt. Jedes Auswahlsignal s1 (k) ... s7 (k) wird in einem eigenen Summierer S1 ... S7 von dem Ausgangssignal u (k) des Teilers T subtrahiert und einem jeweiligen Schleifenfilter SF1 ... SF7 eingangssertig zugeführt, dessen Ausgang mit einem jeweiligen Quantisierer Q1 ... Q7 verbunden ist.

Die Sortierlogik SL sorgt nun dafür, daß entsprechend des Eingangssignals am Eingang IN entsprechend viele DA-Elemente ausgewählt werden, wobei immer die n DA Elemente ausgewahlt werden, deren zugehörige Ausgangssignale am großten sind, wodurch gerade the Rückkoppelschleifen mit den größten Werten eine negative und die Anderen eine positive Rückkopplung erhalten. Die Sortierlogik ist vorteilhafterweise so geartet, daß ein Auswahlsignal gleich 1 ist, sofern ein DA-Element ausgewählt ist und ein Auswahlsignal gleich - 1 ist, sofern das entsprechende DA-Element nicht ausgewählt ist. Die Ausgangssignale für nicht ausgewählte DA-Elemente werden somit insgesamt positiv rückgekoppelt, was dazu führt, daß diese Schleifen bzw. die dazugehörigen DA-Elemente später, wenn die die Ausgangssignale der Quantisierer dadurch entsprechend groß geworden sind, dann an Stelle der Anderen auch ausgewählt werden. Durch die Überabtastung werden somit die Nichtlinearitäten des Wandlers aufgrund der Bauelementetoleranzen bei den DA-Elementen quasi ausgemittelt und damit die Linearität erhöht.

Um nach dem Stand der Technik einen mit dem hier angegebenen Ausführungsbeispiel vergleichbaren DA-Wandler zu erhalten, sind anstelle der vierstufigen Quantisierer Q1 ... Q7 zwölfstufige Quantisierer und zusätzlich eine Minimumdetektionseinheit erforderlich.

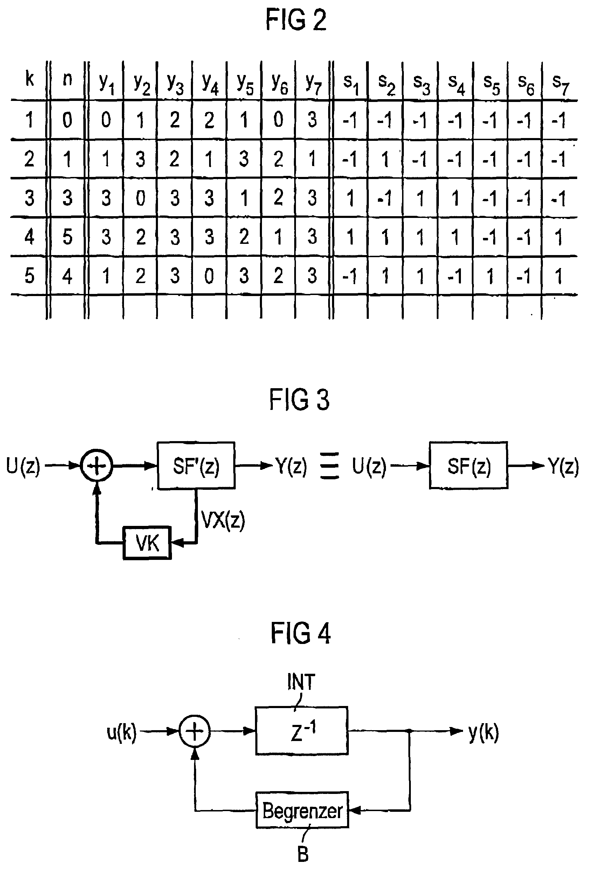

In Figur 2 ist zur Verdeutlichung der Funktion der Sortierlogik SL beispielsweise eine Tabelle mit der Laufvariablen k = 1 ... 5 der Reihe nach für eine verschiedene Anzahl von DA-Elementen n = 0, 1, 3, 5 und 4 bezüglich der Signale y1 ... y7 und der Auswahlsignale S1 ... S7 dargestellt. Bei k = 1 ist n = 0, das heißt, daß überhaupt kein DA-Element ausgewählt werden soll. Bei k = 1 und n = 0 sind die Signale y1 ... y7 gleich 0, 1, 2, 2, 1, 0 und 3 und die Auswahlsignale S1 ... S7 alle minus Eins, da kein einziges DA-Element wegen n = 0 ausgewählt ist. In der Zeile für k = 2 ist n = 1, das heißt, es muß ein einziges DA-Element ausgewählt werden und bei den Signalen y1 ... y7 = 1, 3, 2, 1, 3, 2 und 1 bedeutet dies, daß das Auswahlsignal S2 gleich 1 ist und alle anderen Auswahlsignale gleich - 1 sind, da y2 den ersten größten Wert, nämlichen den Wert 3 hat. Die Zeile für k = 3 behandelt den Fall für n = 3 DA-Elemente, wobei die Signale y1 ... y7 gleich 3, 0, 3, 3, 1, 2 und 3 sind und folglich die zugehörlgen ersten drei größten Auswahlsignale, also S1, S3 und S4 gleich 1 sind und die Restlichen wiederum - 1. Die Zeile für k = 4 behandelt den Fall für n = 5 DA-Elemente, wobei die Signale y1 ... y7 gleich 3, 2, 3, 3, 2, 1 und 3 und die Auswahlsignale bis auf die Auswahlsignale S5 und S6, die wiederum - 1 sind, alle gleich 1 sind. In der letzten Zeile für k = 5 und n = 4 sind die Signale y1 ... y7 1, 2, 3, 0, 3, 2 und 3 und die zugehörigen Auswahlsignale S1, S4 und S6 gleich - 1 und die Auswahlsignale S2, S3, S5 und S7 gleich 1.

Aufgrund der begrenzten Rechengenauigkeit ist es von Vorteil, wenn die M digitalen Delta-Sigma-Modulatoren, also die Schleifenfilter SF1 ... SF7 mit den jeweiligen Quantisierern Q1 ... Q7 auch ohne Rückkopplung stabil sind. Dies kann, wie in Figur 3 dargestellt, durch ein Schleifenfilter mit entsprechender interner Zustandsvektor-Rückführung VK erreicht werden.

Ist die Ordnung der M Delta-Sigma-Modulatoren, also die Ordnung der Schleifenfilter SF1 ... SF7 größer als 2, so kann bei hoher Aussteuerung des Wandlers Instabilität auftreten. Um dies zu vermeiden, ist es vorteilhaft, wenn, wie in Figur 4 dargestellt, im Rückkoppelpfad eines jeden Integrators INT eines Schleifenfilters ein Begrenzer B vorhanden ist, der zu große Werte der Zustandsvariablen vermeidet und wodurch die Integratoren bei geringerer Aussteuerung, von selbst in einen stabilen Zustand zurückkehren.

## Patentansprüche

1. Multi-Bit-Digital/Analog-Wandler (DAC), dessen Eingang (IN) über eine 1/M-Teilerschaltung (T) mit Eingängen von M Summierern (S1 ... S7) verbunden ist,
- bei dem ein Ausgang eines jeweiligen Summierers über ein jeweiliges Schleifenfilter (SF1 ... SF7) mit einem Eingang eines jeweiligen Quantisierers (Q1 ... Q7) verbunden ist,
- bei dem eine Sortierlogikschaltung (SL) vorhanden ist, die eingangsseitig mit Ausgängen der jeweiligen Quantisierer, ausgangsseitig mit jeweiligen DA-Elementen (DA1 ... DA7) und an einem Steuereingang (ST) mit dem Eingang (IN) des Multi-Bit-Digital/Analog-Wandlers verbunden ist und deren jeweilige Ausgangssignale (s1 ... s7) negativ auf einen jeweiligen Eingang der jeweiligen Summierer rückgeführt sind, und
- bei dem ein Ausgangssummierer (DAS) vorhanden ist, der eingangsseitig mit den Ausgängen der jeweiligen DA-Elemente verbunden ist und ein analoges Ausgangssignal (da (k)) liefert.

2. Multi-Bit-Digital/Analog-Wandler nach Anspruch 1, bei dem die Sortierlogik (SL) so ausgebildet ist, daß die Quantisierer nach der Größe ihres Ausgangssignales (y1 ... y7) sortiert werden, und nur eine vom Signal am Eingang (IN) des Multi-Bit-Digital/Analog-Wandlers abhängige Anzahl (n) von DA-Elementen (DA1 ... DA7) mit Ausgängen von Quantisierern mit den größten Ausgangssignalen verbunden werden.

3. Multi-Bit-Digital/Analog-Wandler nach Anspruch 1 oder 2, bei dem die Schleifenfilter (SF) selbst einen internen Rückkoppelpfad (VK) aufweisen.

4. Multi-Bit--Digital/Analog-Wandler nach Anspruch 3,
bei dem Integratoren (INT) in den Schleifenfiltern einen Begrenzer (B) im Rückkoppelpfad aufweisen.

5. Verwendung eines Multi-Bit-Digital/Analog-Wandlers nach einem der vorhergehenden Ansprüche, als D/A-Wandler im Rückkoppelpfad eines Multi-Bit-Delta-Sigma A/D-Wandlers.

## Claims

1. Multibit digital/analogue converter (DAC), whose input (IN) is connected to inputs of M summers (S1 ... S7) via a 1/M divider circuit (T),
- in which an output of a respective summer is connected to an input of a respective quantizer (Q1 ... Q7) via a respective loop filter (SF1 ... SF7),
- in which there is a sorting logic circuit (SL) whose inputs are connected to outputs of the respective quantizers, whose outputs are connected to respective DA elements (DA1 ... DA7) and which is connected to the input (IN) of the multibit digital/analogue converter at a control input (ST), and whose respective output signals (s1 ... s7) are fed back negatively to a respective input of the respective summers, and
- in which there is an output summer (DAS) whose inputs are connected to the outputs of the respective DA elements and which delivers an analogue output signal (da (k)).

2. Multibit digital/analogue converter according to Claim 1,
in which the sorting logic unit (SL) is designed such that the quantizers are sorted on the basis of the magnitude of their output signal (y1 ... y7), and only a number (n) of DA elements (DA1 ... DA7) which is dependent on the signal at the input (IN) or the multibit digital/analogue converter are connected to outputs of quantizers having the largest output signals.

3. Multibit digital/analogue converter according to Claim 1 or 2,
in which the loop filters (SF) themselves have an internal feedback path (VK).

4. Multibit digital/analogue converter according to Claim 3,
in which integrators (INT) in the loop filters have a limiter (B) in the feedback path.

5. Use of a multibit digital/analogue converter according to one of the preceding claims as a D/A converter in the feedback path of a multibit delta-sigma A/D converter.

## Revendications

1. Convertisseur numérique-analogique multibits (DAC) dont l'entrée (IN) est reliée à des entrées de M totalisateurs (S1 ... S7) par l'intermédiaire d'un 1/M circuit diviseur (T),
- une sortie d'un totalisateur respectif étant reliée à une entrée d'un quantificateur (Q1 ... Q7) respectif par l'intermédiaire d'un filtre de boucle (SF1 ... SF7) respectif,
- un circuit logique de tri (SL) étant présent qui côté entrée est relié à des sorties des quantificateurs respectifs, côté sortie à des éléments DA (DA1 ... DA7) respectifs, et sur une entrée de commande (ST), à l'entrée (IN) du convertisseur numérique-analogique multibits, et dont les signaux de sortie respectifs (s1 ... s7) sont reconduits négatifs sur une entrée respective des totalisateurs respectifs, et
- un totalisateur de sortie (DAS) étant présent qui côté entrée est relié aux sorties des éléments DA respectifs et qui fournit un signal de sortie analogique (da (k)).

2. Convertisseur numérique-analogique multibits selon la revendication 1, ou la logique de tri (SL) est configurée en ce que les quantificateurs sont triés selon la grandeur de leur signal de sortie (y1 ... y7) et que seul un nombre (n) d'éléments DA (DA1 ... DA7) dépendant du signal sur l'entrée (IN) du convertisseur numérique-analogique multibits est relié a des sorties de quantificateurs présentant les signaux de sortie les plus importants.

3. Convertisseur numérique-analogique multibits selon la revendication 1 ou 2, où les filtres de boucle (SF) présentent eux-mêmes une branche de réinjection interne (VK).

4. Convertisseur numérique-analogique multibits selon la revendication 3, où des intégrateurs (INT) dans les filtres de boucle présentent un limiteur (b) sur la branche de réinjection.

5. Utilisation d'un convertisseur numerique-analogique multibits selon l'une des revendications précédentes en tant que convertisseur N/A sur la branche de réinjection d'un convertisseur A/N delta sigma multibits.
